# EUROPEAN PATENT APPLICATION

(11) **EP 3 276 363 A1**
(43) Date of publication of application: **31.01.2018**
(21) Application number: 16182083.2
(22) Date of filing: 29.07.2016
(51) Int. Cl.: G01R 31/327, G01R 1/18, G01R 15/06, G01R 15/18, H01H 33/02, H01H 33/26, H02B 13/035, G01R 1/04, G01R 19/32

(54) **SENSING DEVICE AND ASSOCIATED TRANSMISSION LINE**

(71) Applicant: General Electric Technology GmbH, 5400 Baden (CH)
(72) Inventor: JUGE, Patrice, 74150 MARCELLAZ ALBANAIS (FR); VUACHET, Jacques, 74330 POISY (FR)
(74) Representative: Cleary, Fidelma

(57) **Abstract**

The invention concerns a sensing device comprising:
- a voltage sensor, the voltage sensor comprising a reference plate and a sensing plate, the reference plate and the sensing plate being ring-shaped, concentric and arranged at a distance from each other, an inward-facing surface of the reference plate facing an outward-facing surface of the sensing plate, each of the reference plate and the sensing plate being made of an electrically conductive material, the voltage sensor being adapted to output a voltage signal representative of a voltage value between the reference plate and the sensing plate;
- a current sensor, the current sensor comprising a ring shaped Rogowski coil, the current sensor being adapted to output a current signal representative of a current flowing through a conductor encircled by the Rogowski coil.

## Description

### TECHNICAL FIELD

The invention concerns a sensing device comprising:
- a voltage sensor, the voltage sensor comprising a reference plate and a sensing plate, the reference plate and the sensing plate being ring-shaped, concentric and arranged at a distance from each other, an inward-facing surface of the reference plate facing an outward-facing surface of the sensing plate, each of the reference plate and the sensing plate being made of an electrically conductive material, the voltage sensor being adapted to output a voltage signal representative of a voltage value between the reference plate and the sensing plate;
- a current sensor, the current sensor comprising a ring shaped Rogowski coil, the current sensor being adapted to output a current signal representative of a current flowing through a conductor encircled by the Rogowski coil. The invention also concerns a transmission line.

The invention applies to electrical distribution, and more particularly to switchgear.

### BACKGROUND ART

It is known to provide a sensing device within a transmission line, for instance a transmission line designed according to the standards of gas technology. Such sensing devices comprise, for instance, a voltage sensor and a current sensor.

The voltage sensor is usually a capacitive divider sensor, arranged around the central conductor of the transmission line.

The current sensor usually comprises a Rogowski coil. To reduce electromagnetic interference that would entail errors in the current measurement, the Rogowski coil is generally enclosed in a casing acting as a protective shield provided in a wall of the tube.

However, for each sensor, a hole is provided in the pipe of the transmission line to convey the wires of each sensor out of the transmission line. Due to the presence of such holes, leakage of the dielectric gas outside the transmission line can occur, therefore increasing the likelihood of arc creation within the transmission line. Such arcs can severely damage the transmission line and are a potential threat for users.

Moreover, due to the variety of gas gaskets that are employed to prevent gas leakage, such sensing devices are generally expensive, and their maintenance is difficult.

Furthermore, the presence of several sensors with corresponding casings, such as the electromagnetic shield, renders such sensing devices cumbersome and expensive.

The purpose of the invention is to provide a sensing device that is safer, lighter and more cost-effective.

### SUMMARY OF INVENTION

To this end, the present invention is a sensing device of the aforementioned type, wherein the Rogowski coil is concentric with the reference plate and the sensing plate, the reference plate being arranged between the Rogowski coil and the sensing plate, the reference plate shielding the Rogowski coil from the sensing plate, the Rogowski coil being arranged outwardly with respect to the reference plate, and the sensing plate being arranged inwardly with respect to the reference plate.

Indeed, the reference plate acts as a plane that shields the Rogowski coil, such as a ground plane when the reference plane is connected to the ground. Therefore, no specific casing is required for the Rogowski coil. Moreover, such a sensing device requires fewer gas gaskets, since the voltage sensor and the current sensor are co-located.

This allows for a sensing device that is more compact, lighter, cheaper, easier to produce and easier to assemble than the known sensing devices.

Moreover, the reduced number of gas gaskets allows for a lower risk of gas leakage, which entails higher safety.

According to other advantageous aspects of the invention, the sensing device includes one or more of the following characteristics, taken alone or in any possible combination:
- the sensing device further comprises at least one temperature sensor each configured to output a temperature signal representative of the temperature in a corresponding predetermined volume relative to the voltage sensor;
- the sensing device further comprises a casing molded around the reference plate, the sensing plate and the Rogowski coil, the casing being made of a dielectric material;
- the sensing device further comprises a casing molded around the reference plate, the sensing plate, the Rogowski coil and each temperature sensor, the casing being made of a dielectric material;
- the sensing device further comprises a splitter, the splitter having an input connected to the sensing plate, the splitter further comprising a first output forming a low frequency channel and a second output forming an ultra-high frequency channel.

The invention also relates to a transmission line comprising a grounding pipe and at least one conductor arranged within the grounding pipe, the grounding pipe and each conductor being made of an electrically conductive material, the grounding pipe and each conductor extending along a same longitudinal axis, each conductor being spaced apart from the grounding pipe,
the transmission line further comprising, for each conductor, a sensing device as previously defined, the reference plate, the sensing plate and the Rogowski coil of each sensing device being arranged exclusively around the corresponding conductor between the grounding pipe and the corresponding conductor,
the reference plate of each sensing device being electrically connected to the grounding pipe.

According to other advantageous aspects of the invention, the transmission line includes one or more of the following characteristics, taken alone or in any possible combination:
- the transmission line further comprises a computer configured to compute the value of the conductor-to-pipe voltage from the voltage signal outputted by the voltage sensor of each sensing device, the computer being further configured to compute the value of the electric current flowing through each conductor from the current signal outputted by the current sensor of the corresponding sensing device;
- the transmission line further comprises, for each sensing device, a splitter, the splitter having an input connected to the sensing plate, the splitter further comprising a first output forming a low frequency channel and a second output forming an ultra-high frequency channel, the low frequency channel and the ultra-high frequency channel being both connected to the computer, the splitter being configured to convey, through the low frequency channel, a part of the voltage signal having a frequency that is lower than a first predetermined value, and to convey, through the ultra-high frequency channel, a part of the voltage signal having a frequency that is higher than a second predetermined value, the computer being configured to compute, for each sensing device, the value of the conductor-to-pipe voltage from the part of the voltage signal conveyed through the low frequency channel, the computer being further configured to detect partial discharges occurring in the transmission line through the analysis of the part of the voltage signal conveyed through the ultra-high frequency channel;
- for each sensing device, the computer is further configured to correct the measured conductor-to-pipe voltage by using the temperature signal outputted by each temperature sensor in order to compensate for the effects of temperature fluctuations on the geometry of the voltage sensor;
- for each sensing device, the reference plate is electrically connected to the grounding pipe through at least one elastic contacting blade;
- the contacting blades are located on a same edge of the reference plate;
- for each sensing device, the reference plate is electrically connected to the grounding pipe through a wire;
- the transmission line comprises a single conductor, the grounding pipe being provided with a ring-shaped groove on an inward-facing surface of the grounding pipe, the Rogowski coil being arranged in the groove;
- the reference plate is arranged in the groove;
- each sensing device further comprises a casing molded around the reference plate, the sensing plate and the Rogowski coil, the casing being made of a dielectric material, the casing being in mechanical contact with the grounding pipe and the conductor to support the conductor.

### BRIEF DESCRIPTION OF THE DRAWINGS

The invention will be better understood with the attached figures, in which:
- figure 1 is a cross-section detail of a first embodiment of a transmission line according to the invention, in a plane comprising a longitudinal axis of the transmission line;
- figure 2 is a cross-section detail of the transmission line of figure 1, in a plane orthogonal to the longitudinal axis;
- figure 3 is a cross-section detail of a second embodiment of the transmission line according to the invention, in the same plane as in figure 1;
- figure 4 is a cross-section detail of a third embodiment of the transmission line according to the invention, in the same plane as in figure 1;
- figure 5 is a cross-section detail of a fourth embodiment of the transmission line according to the invention, in the same plane as in figure 1;
- figure 6 is a cross-section detail of a fifth embodiment of the transmission line according to the invention, in the same plane as in figure 1;
- figure 7 is a cross-section detail of a sixth embodiment of the transmission line according to the invention, in a plane orthogonal to the longitudinal axis; and
- figure 8 is a cross-section detail of the embodiment of figure 7, along a sectional plane AA.

### DESCRIPTION OF PREFERED EMBODIMENTS

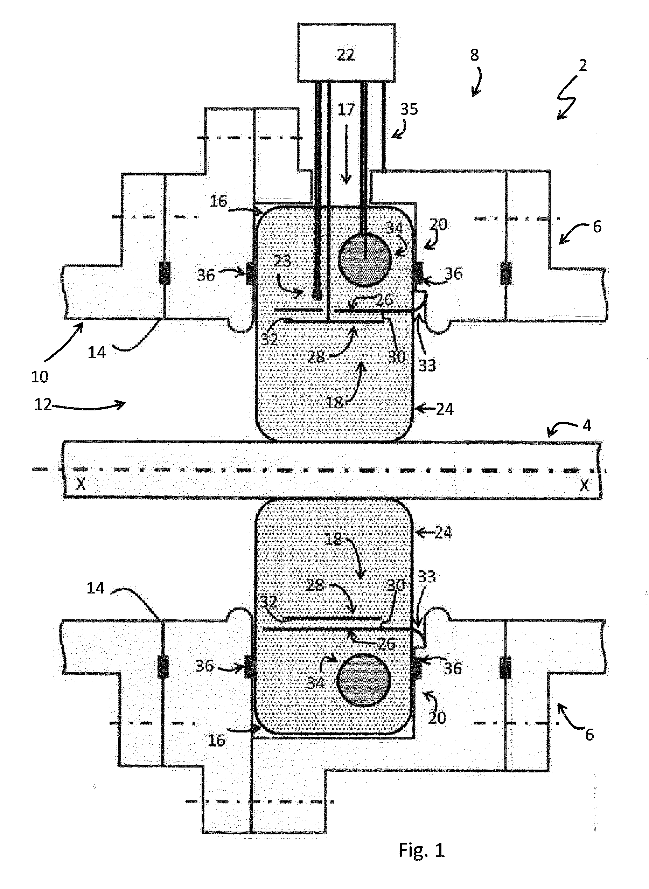

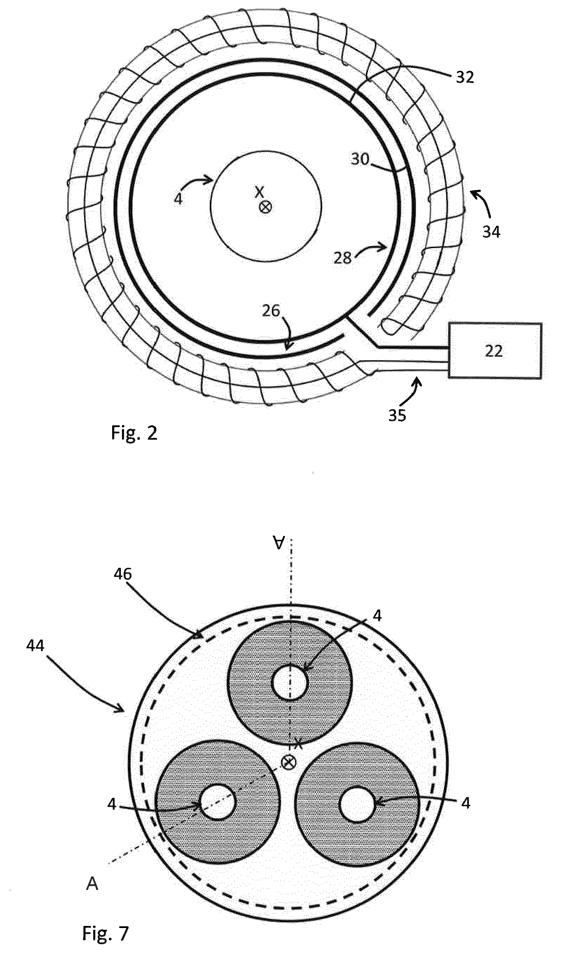

A part of a transmission line 2 according to the invention is shown on figures 1 and 2. The transmission line is designed according to the standards of SF₆ technology (SF₆ standing for "sulfur hexafluoride"). For instance, the transmission line 2 is a part of a gas insulated switchgear.

The transmission line 2 comprises a conductor 4, a grounding pipe 6 enclosing the conductor 4, and a sensing device 8.

The conductor 4 is able to convey electric current from a first end of the transmission line 2 to a second end of the transmission line 2.

As can be seen on figure 1, the grounding pipe 6 has a rotational symmetry around a longitudinal axis X-X. The grounding pipe 6 is configured to be electrically connected to a reference electric potential source, for instance to be connected to the ground. The grounding pipe 6 is also configured to allow the circulation of a reverse current flowing in an opposite direction relative to the current flowing in the conductor 4.

The sensing device 8 is configured to measure the value of the conductor-to-pipe voltage, equal to the difference in electric potential between the conductor 4 and the grounding pipe 6. The sensing device 8 is also configured to compute the value of the electric current flowing through the conductor 4.

Each of the conductor 4 and the grounding pipe 6 is made of an electrically conductive material, such as a metal.

The grounding pipe 6 is a hollow cylinder extending along the longitudinal axis X-X. The grounding pipe 6 comprises a wall 10 defining a cavity 12 inside the grounding pipe 6.

The wall 10 includes an inner-facing surface 14 facing toward the cavity 12. The wall 10 also comprises a groove 16 on the inner-facing surface 14 side.

The groove 16 is ring shaped and is defined in a plane orthogonal to the longitudinal axis X-X. The groove 16 comprises a hole 17 to connect the cavity 12 to the outside of the grounding pipe 6.

The cavity 12 is filled with an insulating gas. For instance, such an insulating gas is sulfur hexafluoride (also known as SF₆).

The conductor 4 is a solid cylinder arranged in the cavity 12 of the grounding pipe 6, the conductor 4 being spaced apart from the grounding pipe 6.

The conductor 4 also extends along the longitudinal axis X-X.

The sensing device 8 comprises a voltage sensor 18, a current sensor 20 and a computer 22. Advantageously, the sensing device 8 also comprises a least one temperature sensor 23. The sensing device 8 further comprises a casing 24 molded around the voltage sensor 18, the current sensor 20 and, preferably, each temperature sensor 23.

The voltage sensor 18 comprises a reference plate 26 and a sensing plate 28. The reference plate 26 and the sensing plate 28 are made of an electrically conductive material. The reference plate 26 and the sensing plate 28 are ring-shaped. For instance, each of the reference plate 26 and the sensing plate 28 is a metallic strip having both ends joined together. For instance, the reference plate 26 and the sensing plate 28 are metallic planes located on opposite sides of a flexible circuit board.

As shown on figure 2, the reference plate 26 and the sensing plate 28 are concentric and arranged at a distance from each other. The sensing plate 28 is arranged inwardly with respect to the reference plate 26. More precisely, the reference plate 26 comprises an inward-facing surface 30 that is directed inwardly towards the longitudinal axis X-X, and the sensing plate 28 comprises an outward-facing surface 32 that is directed outwardly away from the longitudinal axis X-X, the inward-facing surface 30 of the reference plate 26 facing the outward-facing surface 32 of the sensing plate 28.

The reference plate 26 and the sensing plate 28 are arranged within the grounding pipe 6 and around the conductor 4, the reference plate 26 and the sensing plate 28 extending in a plane that is preferably orthogonal to the longitudinal axis X-X.

The reference plate 26 is electrically connected to the grounding pipe 6 to make the electric potential of the reference plate 26 equal to the electric potential of the grounding pipe 6. Advantageously, the reference plate 26 is connected to the grounding pipe 6 through at least one elastic contacting blade 33, the contacted blades 33 being located on a same edge of the reference plate 26. The contacting blades 33 are made of an electrically conductive material such as a copper and beryllium alloy, which has suitable elastic and electric properties for maintaining a mechanical and electrical contact between the contacting blades 33 and the grounding pipe 6.

The voltage sensor 18 is located at the same position along the longitudinal axis X-X as the groove 16. Preferably, the reference plate 26 is arranged in the groove 16, as shown on figure 1.

The voltage sensor 18 is adapted to output a voltage signal representative of a voltage value between the reference plate 26 and the sensing plate 28.

The current sensor 20 comprises a ring shaped Rogowski coil 34 located within the grounding pipe 6 and around the conductor 4. The Rogowski coil 34 defines a plane that is preferably orthogonal to the longitudinal axis X-X.

The Rogowski coil 34 is arranged in the groove 16. Moreover, the Rogowski coil 34 is concentric with the reference plate 26 and the sensing plate 28, the Rogowski coil 34 being arranged outwardly with respect to the reference plate 26, as shown on figure 2. The reference plate 26 shields the Rogowski coil 34 from the sensing plate 28, that is to say that the reference plate 26 is able to stop the electric field lines coming from the sensing plate 28 or coming to the sensing plate 28, the reference plate 26 being at the same voltage potential as the grounding pipe 6.

For instance, the Rogowski coil has a circular cross-section.

The current sensor 20 is able to output a current signal representative of a current flowing through the conductor 4 that is encircled by the Rogowski coil 34.

With reference to figure 1, each temperature sensor 23 is located at a predetermined position relative to the voltage sensor 18. Furthermore, each temperature sensor 23 is configured to output a temperature signal representative of the temperature in a corresponding predetermined volume around the predetermined position relative to the voltage sensor 18.

Each sensor 18, 20, 23 comprises wires 35 that connect the sensors 18, 20, 23 to the computer 22. The wires 35 are conveyed through the hole 17.

As stated previously, the casing 24 is molded around the voltage sensor 18, the current sensor 20 and, preferably, each temperature sensor 23. More precisely, the casing 24 is molded around the reference plate 26, the sensing plate 28, the Rogowski coil 34 and, preferably, each temperature sensor 23.

The casing 24 is made of a dielectric material. Such a dielectric material is, for example, an epoxy resin, an epoxy and aluminium oxide mixture, or plastic. Such a plastic is, for instance, polyurethane, polyester or high-density polyethylene.

The casing 24 extends within the g roove 16. Preferably, gas gaskets 36 are provided between the casing 24 and the wall 10 of the grounding pipe 6, for instance between the casing 24 and the part of the inner facing surface 14 located in the groove 16, to avoid gas leakage outside the transmission line 2 through the hole 17.

Advantageously, the casing 23 is in mechanical contact with the grounding pipe 6 and the conductor 4 to support the conductor.

The computer 22 is configured to compute the value of the conductor-to-pipe voltage from the voltage signal outputted by the voltage sensor 18. Advantageously, the computer 22 is further configured to correct the measured conductor-to-pipe voltage by using the temperature signal outputted by each temperature sensor 23 in order to compensate for the effects of temperature fluctuations on the geometry of the voltage sensor 18.

Moreover, the computer 22 is configured to compute the value of the electric current flowing through the conductor 4 from the current signal outputted by the current sensor 20.

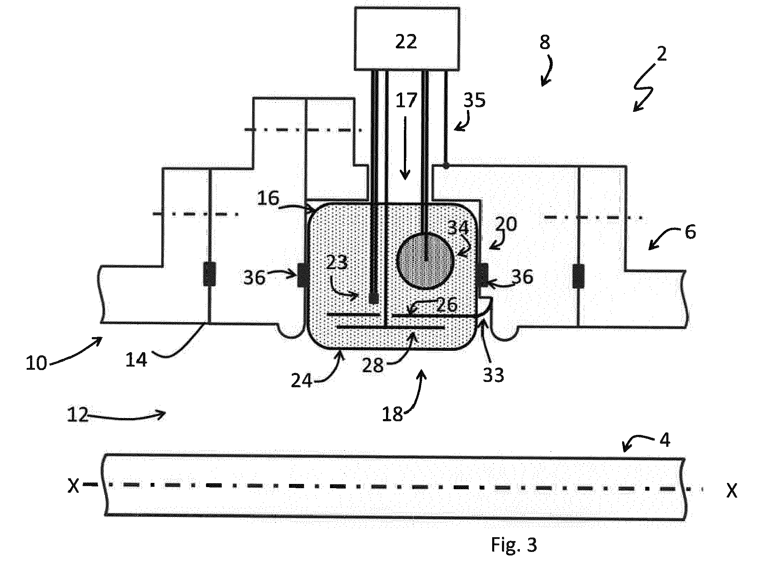

In a second embodiment of the transmission line 2, shown on figure 3, the casing 24 does not support the conductor 4 (the lower part of the cross-section is not shown for clarity purposes).

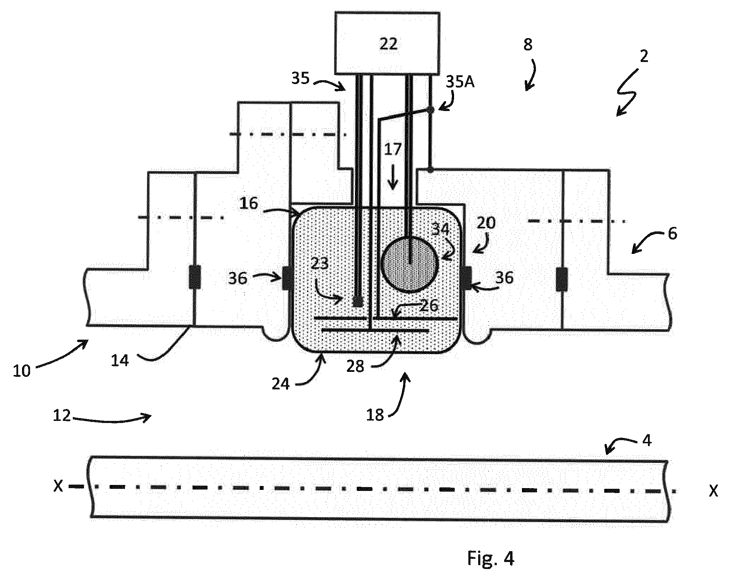

In a third embodiment of the transmission line 2, no contacting blades 33 are provided. In this case, the reference plate 26 is connected to the grounding pipe through at least one wire 35A, as shown on figure 4 (the lower part of the cross-section is not shown for clarity purposes).

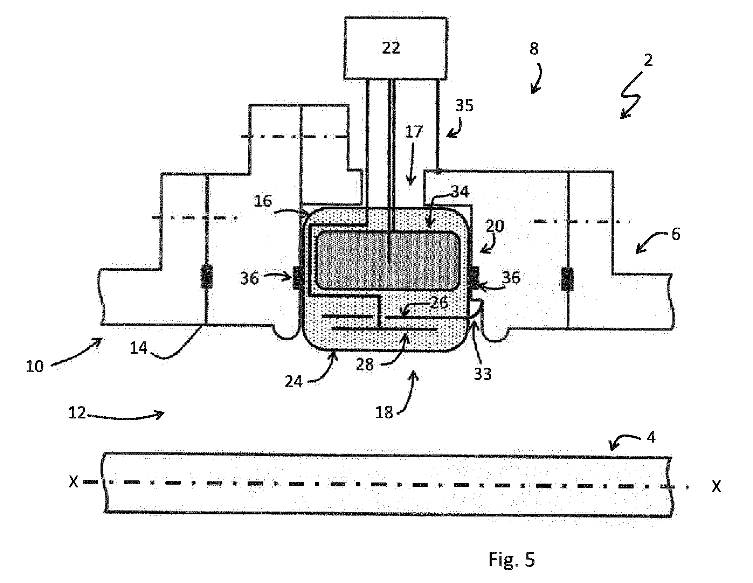

In a fourth embodiment of the transmission line 2, the Rogowski coil 34 has a rectangular cross-section, as shown on figure 5 (the temperature sensor 23 and the lower part of the cross-section are not shown for clarity purposes). In such an embodiment, the rectangular cross-sectional area is greater than the circular cross-sectional area of the previous embodiment, which provides for a higher sensitivity.

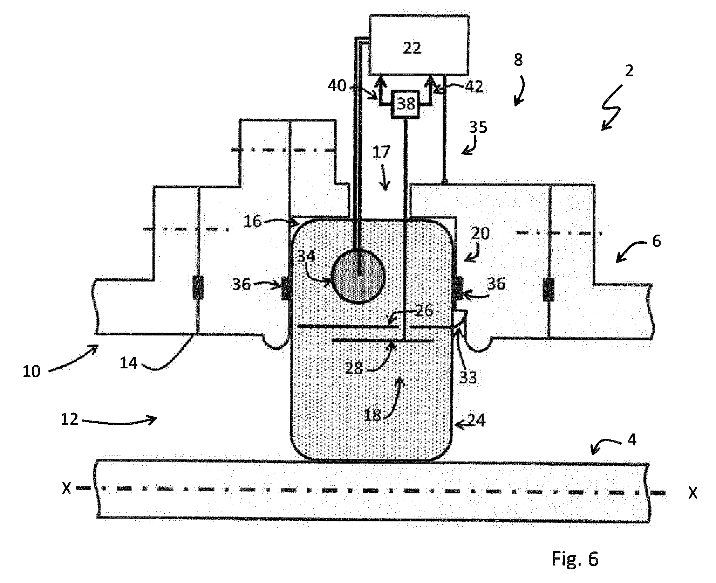

In a fifth embodiment of the transmission line 2, the sensing device 8 comprises a splitter 38, as shown on figure 6 (the temperature sensor 23 and the lower part of the cross-section are not shown for clarity purposes).

The splitter 38 comprises an input that is connected to the sensing plate 28. The splitter 38 further comprises a first output forming a low frequency (LF) channel 40 and a second output forming an ultra-high frequency (UHF) channel 42, both channels 40, 42 being connected to the computer 22. The splitter 38 is configured to convey, through the LF channel 40, a part of the voltage signal having a frequency that is lower than a first predetermined value, for instance 10 kHz (kilohertz). Moreover, the splitter 38 is configured to convey, through the UHF channel 42, a part of the voltage signal having a frequency that is higher than a second predetermined value, for instance 300 to 1200 MHz (megahertz). In this case, the computer 22 is configured to compute the value of the conductor-to-pipe voltage from the part of the voltage signal conveyed through the LF channel 40. The computer 22 is further configured to detect partial discharges occurring in the transmission line 2 through the analysis of the part of the voltage signal conveyed through the UHF channel 42.

In a sixth embodiment of the transmission line 2, three conductors 4 are provided within the grounding pipe 6, as shown on figure 7. The conductors 4 are spaced apart from one another. Each conductor corresponds to a respective electric phase.

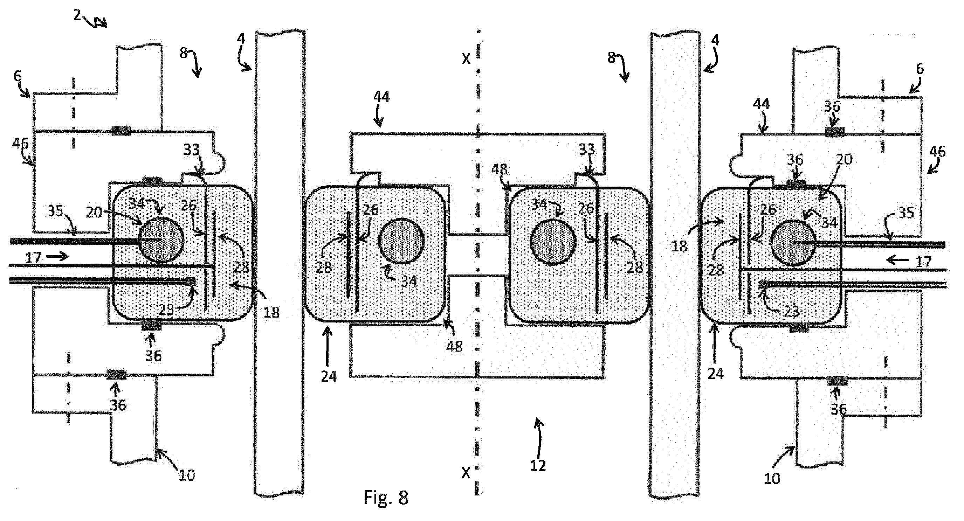

Moreover, a sensing device 8 as described above is provided for each conductor 4, as shown on figure 8.

The sensing plate 28 and the Rogowski coil 34 of each sensing device 8 are arranged exclusively around the corresponding conductor 4, between the grounding pipe 6 and the corresponding conductor 4.

Preferably, a flange 44 is provided to support each conductor 4.

The flange 44 is made of an electrically conductive material.

For instance, as shown on figure 7, the flange 44 is disc-shaped. The flange 44 comprises a rim 46 for mechanically and electrically connecting the flange 44 to the grounding tube 6, as shown on figure 8.

For each conductor 4, the flange 44 comprises a depression 48 configured to receive the casing 24 of the corresponding sensing device 8, and the voltage sensor 18, the current sensor 20 and the temperature sensors 23 embedded in the casing 24. For instance, the depression 48 has a shape that is complementary to the shape of the casing 24 arranged in the depression 48.

Furthermore, the reference plate 26 of each sensing device 8 is electrically connected to the flange 4.

Preferably, a single computer 22 is provided to process the signal coming from each sensing device 8.

The sensing device according to the invention is more compact, lighter, cheaper and easier to produce, and easier to assemble than the known sensing devices.

The sensing device according to the invention also provides more reliable and precise voltage and current measurements.

Moreover, such a sensing device requires fewer gas gaskets, and reduces the risk of gas leakage, which entails higher safety.

In the transmission line 2 according to the invention, since the reference plate 26 acts as a ground plane that shields the Rogowski coil 34, no additional shield is required. Therefore, the casing 24 is in direct contact with the Rogowski coil 34, which stabilizes the geometry of the Rogowski coil 34. This allows for a higher precision regarding the current measurement.

## Claims

1. A sensing device (8) comprising:
- a voltage sensor (18), the voltage sensor (18) comprising a reference plate (26) and a sensing plate (28), the reference plate (26) and the sensing plate (28) being ring-shaped, concentric and arranged at a distance from each other, an inward-facing surface of the reference plate (26) facing an outward-facing surface of the sensing plate (28), each of the reference plate (26) and the sensing plate (28) being made of an electrically conductive material, the voltage sensor (18) being adapted to output a voltage signal representative of a voltage value between the reference plate (26) and the sensing plate (28);
- a current sensor, the current sensor comprising a ring shaped Rogowski coil (34), the current sensor being adapted to output a current signal representative of a current flowing through a conductor (4) encircled by the Rogowski coil (34);
the sensing device (8) being **characterized in that** the Rogowski coil (34) is concentric with the reference plate (26) and the sensing plate (28), the reference plate (26) being arranged between the Rogowski coil (34) and the sensing plate (28), the reference plate (26) shielding the Rogowski coil (34) from the sensing plate (28), the Rogowski coil (34) being arranged outwardly with respect to the reference plate (26), and the sensing plate (28) being arranged inwardly with respect to the reference plate (26).

2. The sensing device (8) according to claim 1, further comprising at least one temperature sensor each configured to output a temperature signal representative of the temperature in a corresponding predetermined volume relative to the voltage sensor (18).

3. The sensing device (8) according to claim 1 or 2, further comprising a casing (24) molded around the reference plate (26), the sensing plate (28) and the Rogowski coil (34), the casing (24) being made of a dielectric material.

4. The sensing device (8) according to claim 2, further comprising a casing (24) molded around the reference plate (26), the sensing plate (28), the Rogowski coil (34) and each temperature sensor, the casing (24) being made of a dielectric material.

5. The sensing device (8) according to any one of claims 1 to 4, further comprising a splitter (38), the splitter (38) having an input connected to the sensing plate (28), the splitter (38) further comprising a first output forming a low frequency channel (40) and a second output forming an ultra-high frequency channel (42).

6. A transmission line (2) comprising a grounding pipe (6) and at least one conductor (4) arranged within the grounding pipe (6), the grounding pipe (6) and each conductor (4) being made of an electrically conductive material, the grounding pipe (6) and each conductor (4) extending along a same longitudinal axis (X-X), each conductor (4) being spaced apart from the grounding pipe (6),
the transmission line (2) further comprising, for each conductor (4), a sensing device (8) according to any one of claims 1 to 5, the reference plate (26), the sensing plate (28) and the Rogowski coil (34) of each sensing device (8) being arranged exclusively around the corresponding conductor (4) between the grounding pipe (6) and the corresponding conductor (4),
the reference plate (26) of each sensing device (8) being electrically connected to the grounding pipe (6).

7. The transmission line (2) according to claim 6, further comprising a computer (22) configured to compute the value of the conductor-to-pipe voltage from the voltage signal outputted by the voltage sensor (18) of each sensing device (8), the computer being further configured to compute the value of the electric current flowing through each conductor (4) from the current signal outputted by the current sensor (20) of the corresponding sensing device (8).

8. The transmission line (2) according to claim 7, further comprising, for each sensing device (8), a splitter (38), the splitter (38) having an input connected to the sensing plate (28), the splitter (38) further comprising a first output forming a low frequency channel (40) and a second output forming an ultra-high frequency channel (42), the low frequency channel (40) and the ultra-high frequency channel (42) being both connected to the computer (22), the splitter (38) being configured to convey, through the low frequency channel (40), a part of the voltage signal having a frequency that is lower than a first predetermined value, and to convey, through the ultra-high frequency channel (42), a part of the voltage signal having a frequency that is higher than a second predetermined value, the computer (22) being configured to compute, for each sensing device (8), the value of the conductor-to-pipe voltage from the part of the voltage signal conveyed through the low frequency channel (40), the computer (22) being further configured to detect partial discharges occurring in the transmission line (2) through the analysis of the part of the voltage signal conveyed through the ultra-high frequency channel (42).

9. The transmission line (2) according to claim 7 or 8, wherein, for each sensing device (8), the computer (22) is further configured to correct the measured conductor-to-pipe voltage by using the temperature signal outputted by each temperature sensor (23) in order to compensate for the effects of temperature fluctuations on the geometry of the voltage sensor (18).

10. The transmission line (2) according to any one of claims 6 to 9, wherein, for each sensing device (8), the reference plate (26) is electrically connected to the grounding pipe (6) through at least one elastic contacting blade (33).

11. The transmission line (2) according to claim 10, wherein the contacting blades (33) are located on a same edge of the reference plate (26).

12. The transmission line (2) according to any one of claims 6 to 9, wherein, for each sensing device (8), the reference plate (26) is electrically connected to the grounding pipe (6) through a wire (35A).

13. The transmission line (2) according to any one of claims 6 to 12, wherein the transmission line (2) comprises a single conductor (4), the grounding pipe (6) being provided with a ring-shaped groove (16) on an inward-facing surface of the grounding pipe (6), the Rogowski coil (34) being arranged in the groove (16).

14. The transmission line (2) according to claim 13, wherein the reference plate (26) is arranged in the groove (16).

15. The transmission line (2) according to any of claims 6 to 14, wherein each sensing device (8) further comprises a casing (24) molded around the reference plate (26), the sensing plate (28) and the Rogowski coil (34), the casing (24) being made of a dielectric material, the casing (24) being in mechanical contact with the grounding pipe (6) and the conductor (4) to support the conductor (4).
